# EUROPÄISCHE PATENTSCHRIFT

(11) **EP 4 013 609 B1**
(45) Veröffentlichungstag und Bekanntmachung des Hinweises auf die Patenterteilung: **27.09.2023**
(21) Anmeldenummer: 20740345.2
(22) Anmeldetag: 21.07.2020
(51) Int. Cl.: B32B 17/06, B32B 17/10, H03K 17/96

(54) **VERBUNDSCHEIBE MIT BEIDSEITIGER SENSORANORDNUNG**
COMPOSITE PANE WITH SENSOR ASSEMBLY ON BOTH SIDES
PANNEAU COMPOSITE POURVUE D'UN ASSEMBLAGE CAPTEUR SUR LES DEUX CÔTÉS

(30) Priorität: 13.08.2019 EP 19191457
(43) Veröffentlichungstag der Anmeldung: 22.06.2022
(73) Patentinhaber: Saint-Gobain Glass France, 92400 Courbevoie (FR)
(72) Erfinder: WEBER, Patrick, 52477 Alsdorf (DE); ZEISS, Michael, 52525 Heinsberg-Haaren (DE); EFFERTZ, Christian, 52080 Aachen (DE); VARGA, Gabor, 52134 Herzogenrath (DE)
(74) Vertreter: Gebauer, Dieter Edmund
(86) Internationale Anmeldenummer: PCT/EP2020/070505
(87) Internationale Veröffentlichungsnummer: WO 2021/028163

(56) Entgegenhaltungen:
- EP-A1- 1 686 026
- WO-A1-2014/037016
- WO-A1-2016/116372
- WO-A1-2018/215106
- DE-A1-102008 043 610

## Beschreibung

Die Erfindung betrifft eine Verbundscheibe mit beidseitiger Sensoranordnung.

Es ist aus der europäischen Patentanmeldung EP 3 264 242 A1 bekannt, einen Berührungssensor als Schaltelement mit einer Leuchtanzeige in einer Glasscheibe zu integrieren. Eine ähnliche Anordnung ist aus der europäischen Patentanmeldung EP 3 264 241 A1 bekannt.

Aus der internationalen Patentanmeldung WO 2016 / 116 372 A1 ist eine Anordnung von zwei nebeneinanderliegenden Berührungssensoren bekannt.

Kapazitive Berührungssensoren haben die Eigenschaft nicht ohne weitere Maßnahmen unterscheiden zu können, von welcher Seite aus der Berührungssensor betätigt wird.

Aus der WO 2018 / 215 106 A1 sind ein Berührungssensor und ein Regensensor bekannt, die durch eine jeweils unterschiedliche relative Positionierung asymmetrisch, d.h. jeweils ein Sensor ist näher zu einer anderen Scheibenoberfläche, positioniert sind.

Dies ist nur dadurch möglich, dass der Berührungssensor näher zu einer Oberfläche der Scheibe angeordnet wird als zu einer anderen Oberfläche. Mit Nähe wird hier der Abstand in normaler Richtung zur flächenhaften Erstreckung des kapazitiv-sensitiven Bereiches aufgefasst.

Um dennoch eine Fehlbedienung zu vermeiden muss dann aber der Sensor soweit intensiv ausgewertet werden, dass eine kapazitive Beeinflussung von der "ungewünschten" Seite zu keinem Schalterfolg führt. Damit sinkt aber in aller Regel auch der Bereich, in dem eine kapazitive Beeinflussung von der "gewünschten" Seite zu einem Schalterfolg führt.

Um dieser Einschränkung entgegen zu wirken, wurde daher in der Vergangenheit vorgeschlagen, eine Schirmung einzuführen, sodass eine kapazitive Beeinflussung von der "ungewünschten" Seite abgeschirmt wird und somit zu keinem Schalterfolg führt.

Werden jedoch zwei Berührungssensoren auf unterschiedlichen Seiten benötigt, so wird entweder eine seitlich versetzte Anordnung der Berührungssensoren nötig oder aber auf Grund der Bauweise ergibt sich eine vergleichsweise dicke Anordnung aus einer elektrisch leitfähigen Schicht mit dem ersten Berührungssensor, einer Isolationsschicht und einer nachfolgenden Schirmungsschicht, woraufhin dann eine weitere Isolationsschicht hin zu einer zweiten elektrisch leitfähigen Schicht mit dem zweiten Berührungssensor benötigt wurde.

Die Nebeneinanderordnung von Sensoren ist raumgreifend und führt dazu, dass der optisch nutzbare Bereich verkleinert wird. Hier sind sowohl praktisch als auch normative Grenzen einzuhalten, sodass eine Nebeneinanderordnung nicht immer möglich ist. Zudem wäre es häufig wünschenswert die Anschlüsse nicht verteilt, sondern konzentriert an andere elektrische Systeme bereitzustellen.

Werden jedoch Berührungssensoren in der bekannten Art gestockt tritt häufig das Problem auf, dass Verbundscheiben zu dick werden. Mit zunehmendem Dicken werden Verbundglasscheiben auch schwerer. Beides sind unerwünschte Phänomene, da z.B. Einfügebreiten häufig ein bestimmtes Maß nicht überschreiten dürfen oder aber es eine Anforderung ist, das Gewicht, z.B. bei Fahrzeugen, gering zu halten, sodass die Nutzlast hochgehalten werden kann bzw. weniger Antriebsenergie für die Fortbewegung benötigt wird.

Ausgehend hiervon ist es eine Aufgabe der Erfindung eine verbesserte Verbundglasscheibe zur Verfügung zu stellen, bei der ein Problem oder mehrere Probleme aus dem Stand der Technik vermieden werden.

Die Aufgabe wird gelöst durch eine Verbundscheibe mit beidseitiger Sensoranordnung, aufweisend eine erste Substratschicht und eine zweite Substratschicht, eine erste strukturierte elektrisch leitende Schicht und eine zweite strukturierte elektrisch leitende Schicht, sowie eine Isolationsschicht, wobei in der ersten elektrisch leitenden Schicht ein erstes kapazitiv-sensitives Element mit einer ersten Zuleitungsstruktur und in der zweiten elektrisch leitenden Schicht ein zweites kapazitiv-sensitives Element mit einer zweiten Zuleitungsstruktur gebildet ist, wobei die erste strukturierte elektrisch leitende Schicht und die zweite strukturierte elektrisch leitende Schicht zumindest durch die Isolationsschicht voneinander getrennt sind, wobei die Anordnung aus erster strukturierter elektrisch leitender Schicht, zweiter strukturierter elektrisch leitender Schicht sowie der Isolationsschicht zwischen der ersten Substratschicht und der zweiten Substratschicht angeordnet ist, wobei das erste kapazitiv-sensitive Element relativ zum zweiten kapazitiv-sensitiven Element versetzt angeordnet ist, sodass zumindest Teile der ersten strukturierten elektrisch leitenden Schicht eine Abschirmung für das zweite kapazitiv-sensitive Element und zumindest Teile der zweiten strukturierten elektrisch leitenden Schicht eine Abschirmung für das erste kapazitiv-sensitive Element bilden.

Dabei macht eine Überdeckung von Elementen des ersten kapazitiv-sensitiven Elementes und der ersten Zuleitungsstruktur kleiner oder gleich 10 % der Fläche des zweiten kapazitiv-sensitiven Elementes aus.

Dies hat den Vorteil, auf engem Raum zwei Berührungssensoren mit einem Wirkbereich auf unterschiedlichen Seiten einer Verbundglasscheibe zur Verfügung zu stellen, wobei nur wenige Schichten benötigt werden, aber dennoch eine Entkoppelung der Berührungssensoren bereitgestellt wird, sodass die Berührungssensoren sensitiv ausgestaltet werden können.

D.h. Teile der Sensoren können sich überlappen. Bei einer geringen Überlappung ist die kapazitive Beeinflussung von der "ungewünschten" Seite so gering, dass die Sensitivität nicht nachhaltig auf der "gewünschten" Seite beeinträchtigt wird.

In einer weiteren Ausführungsform der Erfindung weist die erste strukturierte elektrisch leitende Schicht und / oder die zweite strukturierte elektrisch leitende Schicht eine Höhe von 10 µm - 75 µm, insbesondere 35 µm oder besonders bevorzugt 50 µm, auf.

Dies ermöglicht eine dünne Anordnung, die auch in eine Verbundscheibe integriert werden kann bzw. die auch an eine gebogene Oberfläche angepasst werden kann.

In noch einer weiteren Ausführungsform der Erfindung weist die erste strukturierte elektrisch leitende Schicht und / oder die zweite strukturierte elektrisch leitende Schicht Kupfer, Zinn, Silber Indiumzinnoxid, Gold, Graphene und/oder Mischungen hiervon auf.

D.h. die Erfindung kann in bestehende Prozesse gut und kostengünstig eingebunden werden.

Gemäß einer weiteren Ausführungsform der Erfindung ist die Isolationsschicht eine Folie.

D.h. die Erfindung kann in bestehende Prozesse gut und kostengünstig eingebunden werden.

Gemäß noch einer weiteren Ausführungsform der Erfindung ist die Isolationsschicht eine Folie und die erste strukturierte elektrisch leitende Schicht und / oder die zweite strukturierte elektrisch leitende Schicht sind auf der Folie aufgebracht.

Hierdurch kann die Folie F mit einer oder zwei strukturierten elektrisch leitenden Schichten vorkonfektioniert für die Einbringung in eine Verbundglasscheibe bereitgestellt werden.

In einer Ausführungsform der Erfindung ist die erste Substratschicht und / oder die zweite Substratschicht ein Glas oder Kunststoffsubstrat.

In noch einer weiteren Ausführungsform der Erfindung ist die erste Substratschicht und / oder die zweite Substratschicht ausgewählt aus einer Gruppe aufweisend Flachglas, Floatglas, Quarzglas, Borosilikatglas, Kalk-Natron-Glas, Polyethylen, Polypropylen, Polycarbonat, Polymethylmethacrylat, Polystyrol, Polyamid, Polyester, Polyvinylchlorid und/oder Gemische davon.

D.h. die Erfindung kann in bestehende Prozesse gut und kostengünstig eingebunden werden.

Gemäß einer weiteren Ausführungsform der Erfindung weist die Isolationsschicht zumindest ein Material ausgewählt aus der Gruppe aufweisend Polyimid, Polyurethan, Polymethylenmetacrylsäure, Polykarbonat, Polyethylenterephthalat, Polyvinylbutyral, FR6, Acrylnitril-butadien-Styrol- Copolymerisat, Polyethylen, Polypropylen, Polyvinylchlorid, Polystyrol, Polybutylenterephthalat, Polyamid auf.

Die erfindungsgemäße Verbundglasscheibe kann in Ausführungsformen der Erfindung als Fahrzeugscheibe bzw. als Teil einer Gebäudeverglasung oder in einem Display verwendet werden

Im Folgenden wird die Erfindung anhand einer Zeichnung und Ausführungsbeispielen näher erläutert. Die Zeichnung ist eine schematische Darstellung und nicht maßstabsgetreu. Die Zeichnung schränkt die Erfindung in keiner Weise ein.

Es zeigen:
- Fig. 1: eine schematische Übersicht in Bezug auf die Anordnung von Folien, Substratschicht(en) zur Verdeutlichung von Aspekten gemäß der Erfindung,
- Fig. 2: eine schematische Aufsicht auf elektrisch leitende Schichten, wobei die erste elektrisch leitende Schicht auf einer Oberseite angeordnet ist,
- Fig. 3: eine schematische Aufsicht auf elektrisch leitende Schichten, wobei die zweite elektrisch leitende Schicht auf einer Oberseite angeordnet ist,
- Fig. 4: eine schematische Ansicht der als Berührungssensoren wirkenden Teile unter Weglassung der schirmenden Teile, wobei die zweite elektrisch leitende Schicht auf einer Oberseite angeordnet ist, und
- Fig. 5: eine schematische Ansicht der als Berührungssensoren wirkenden Teile mit schirmenden Teilen, wobei die zweite elektrisch leitende Schicht auf einer Oberseite angeordnet ist.

Nachfolgend wird die Erfindung eingehender unter Bezugnahme auf die Figuren dargestellt werden. Dabei ist anzumerken, dass unterschiedliche Aspekte beschrieben werden, die jeweils einzeln oder in Kombination zum Einsatz kommen können. D.h. jeglicher Aspekt kann mit unterschiedlichen Ausführungsformen der Erfindung verwendet werden soweit nicht explizit als reine Alternative dargestellt.

Weiterhin wird nachfolgend der Einfachheit halber in aller Regel immer nur auf eine Entität Bezug genommen. Soweit nicht explizit vermerkt, kann die Erfindung aber auch jeweils mehrere der betroffenen Entitäten aufweisen. Insofern ist die Verwendung der Wörter "ein", "eine" und "eines" nur als Hinweis darauf zu verstehen, dass in einer einfachen Ausführungsform zumindest eine Entität verwendet wird.

Soweit nachfolgend Verfahren beschrieben werden, sind die einzelnen Schritte eines Verfahrens in beliebiger Reihenfolge anordbar und/oder kombinierbar, soweit sich durch den Zusammenhang nicht explizit etwas Abweichendes ergibt. Weiterhin sind die Verfahren - soweit nicht ausdrücklich anderweitig gekennzeichnet - untereinander kombinierbar.

Angaben mit Zahlenwerten sind in aller Regel nicht als exakte Werte zu verstehen, sondern beinhalten auch eine Toleranz von +/- 1 % bis zu +/- 10 %.

Soweit in dieser Anmeldung Normen, Spezifikationen oder dergleichen benannt werden, werden zumindest immer auf die am Anmeldetag anwendbaren Normen, Spezifikationen oder dergleichen in Bezug genommen. D.h. wird eine Norm / Spezifikation etc. aktualisiert oder durch einen Nachfolger ersetzt, so ist die Erfindung auch hierauf anwendbar.

In den Figuren sind verschieden Ausführungsformen dargestellt. Nachfolgend wird Berührungssensor im Sinne des kapazitiven Näherungssensors verstanden werden. D.h. in aller Regel bedarf es keiner Berührung, sondern einer Annäherung, um die Kapazität zu beeinflussen. Die Schaltfläche des Berührungssensors bildet dabei eine Flächenelektrode aus. Über eine kapazitive Sensorelektronik wird die Kapazität der Flächenelektrode gemessen. Die Kapazität der Flächenelektrode ändert sich gegen Erde, wenn ein geerdeter Körper in ihre Nähe kommt oder beispielsweise eine isolierende Schicht über der Flächenelektrode berührt. Die isolierende Schicht kann z.B. durch ein Substrat Gs1, Gs2 gebildet sein. Die Kapazitätsänderung wird durch die Sensorelektronik gemessen und bei Überschreiten eines Schwellwertes wird ein Schaltsignal ausgelöst. Der Schaltbereich wird durch Form und Größe der Flächenelektrode mitbestimmt.

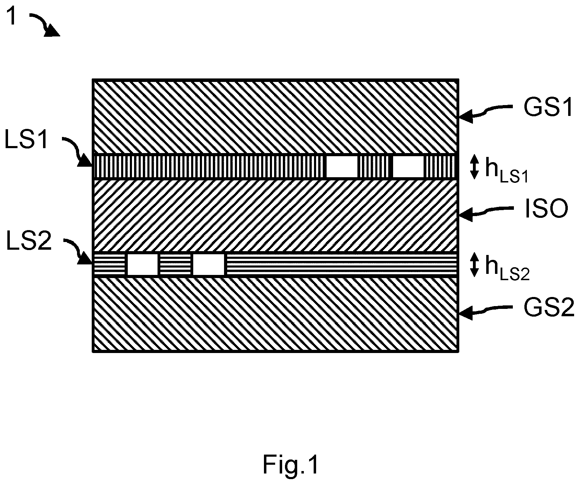

Figur 1 zeigt dabei eine schematische Übersicht in Bezug auf die Anordnung von Folien, Substratschicht(en) zur Verdeutlichung von Aspekten gemäß der Erfindung.

Dabei wird eine Verbundscheibe 1 mit beidseitiger Sensoranordnung im schematischen Schnitt gezeigt.

Die Verbundscheibe 1 weist eine erste Substratschicht GS1 und eine zweite Substratschicht GS2 auf.

Weiterhin weist die Verbundscheibe 1 eine erste strukturierte elektrisch leitende Schicht LS1 und eine zweite strukturierte elektrisch leitende Schicht LS2 sowie eine Isolationsschicht ISO auf.

In der ersten elektrisch leitenden Schicht LS1 ist ein erstes kapazitiv-sensitives Element SW1 mit einer ersten Zuleitungsstruktur V1 gebildet. Das erste kapazitiv-sensitive Element SW1 kann z.B. so ausgestaltet sein, dass es in seiner Größe einer durchschnittlichen Fingerkuppengröße entspricht. Das erste kapazitiv-sensitive Element SW1 weist bevorzugt eine Fläche von 1 cm² bis 200 cm², besonders bevorzugt von 1 cm² bis 10 cm² auf. Das erste kapazitiv-sensitive Element SW1 kann beispielsweise die Form eines Ovals, einer Ellipse oder eines Kreises, eines Dreiecks, eines Rechtecks, eines Quadrats oder eines anders gearteten Vierecks oder eines höheren Polygons aufweisen. Insbesondere sind kreisförmige, elliptische oder tropfenförmige Formen oder Formen mit abgerundeten Ecken sowie Streifenformen besonders vorteilhaft.

Optional kann weiterhin ein (gegenüber der Zuleitungsstruktur V1) vergrößerter Anschlussbereich AB1 gebildet sein, um z.B. eine Kontaktierung an andere elektrische Einrichtungen zu erleichtern.

In der zweiten elektrisch leitenden Schicht LS2 ist ein zweites kapazitiv-sensitives Element SW2 mit einer zweiten Zuleitungsstruktur V2 gebildet. Das zweite kapazitiv-sensitive Element SW2 kann z.B. so ausgestaltet sein, dass es ebenfalls in seiner Größe einer durchschnittlichen Fingerkuppengröße entspricht. Das zweite kapazitiv-sensitive Element SW2 weist bevorzugt eine Fläche von 1 cm² bis 200 cm², besonders bevorzugt von 1 cm² bis 10 cm² auf. Das zweite kapazitiv-sensitive Element SW2 kann beispielsweise die Form eines Ovals, einer Ellipse oder eines Kreises, eines Dreiecks, eines Rechtecks, eines Quadrats oder eines anders gearteten Vierecks oder eines höheren Polygons aufweisen. Insbesondere sind kreisförmige, elliptische oder tropfenförmige Formen oder Formen abgerundeter Ecken sowie Streifenformen besonders vorteilhaft.

Die erste strukturierte elektrisch leitende Schicht LS1 und die zweite strukturierte elektrisch leitende Schicht LS2 sind zumindest durch die Isolationsschicht ISO voneinander getrennt.

Die Anordnung aus erster strukturierter elektrisch leitender Schicht LS1, zweiter strukturierter elektrisch leitender Schicht LS2 sowie der Isolationsschicht ISO ist zwischen der ersten Substratschicht GS1 und der zweiten Substratschicht GS2 angeordnet.

Das erste kapazitiv-sensitive Element SW1 ist relativ zum zweiten kapazitiv-sensitiven Element SW2 in seiner räumlich flächenhaften Erstreckung versetzt zu diesem angeordnet, sodass zumindest Teile der ersten strukturierten elektrisch leitenden Schicht LS1 eine Abschirmung für das zweite kapazitiv-sensitive Element SW2 und zumindest Teile der zweiten strukturierten elektrisch leitenden Schicht L2 eine Abschirmung für das erste kapazitiv-sensitive Element SW1 bilden.

D.h. zumindest Teile der ersten strukturierten elektrisch leitenden Schicht LS1, die nicht Teil des ersten kapazitiv-sensitiven Elements SW1 sind, bilden eine Abschirmung für das zweite kapazitiv-sensitive Element SW2. Zumindest Teile der zweiten strukturierten elektrisch leitenden Schicht LS2, die nicht Teil des zweiten kapazitiv-sensitiven Elements SW2 sind, bilden eine Abschirmung für das erste kapazitiv-sensitive Element SW1.

Dies hat den Vorteil auf engem Raum zwei Berührungssensoren mit einem Wirkbereich auf unterschiedlichen Seiten einer Verbundglasscheibe zur Verfügung zu stellen, wobei nur wenige Schichten benötigt werden, aber dennoch eine Entkoppelung der Berührungssensoren bereitgestellt wird, sodass die Berührungssensoren sensitiv ausgestaltet werden können.

Somit können auf kleinem Raum Berührungssensoren zur Verfügung gestellt werden. D.h. in einem beschränkten Bereich, der für solche Berührungssensoren zur Verfügung steht, können nunmehr auf beiden Seiten der Verbundscheibe 1 Berührungssensoren zur Verfügung gestellt werden, sodass es im günstigen Fall zu einer Verdopplung der Anzahl von Berührungssensoren auf einer beschränkten Fläche kommen kann.

Zudem kann die Dicke einer Verbundscheibe 1 geringgehalten werden, da nicht mehr Schichten als bei einer einseitigen Sensoranordnung benötigt werden. Hierdurch kann Gewicht gespart werden als auch bisherige Einfügebreiten eingehalten werden.

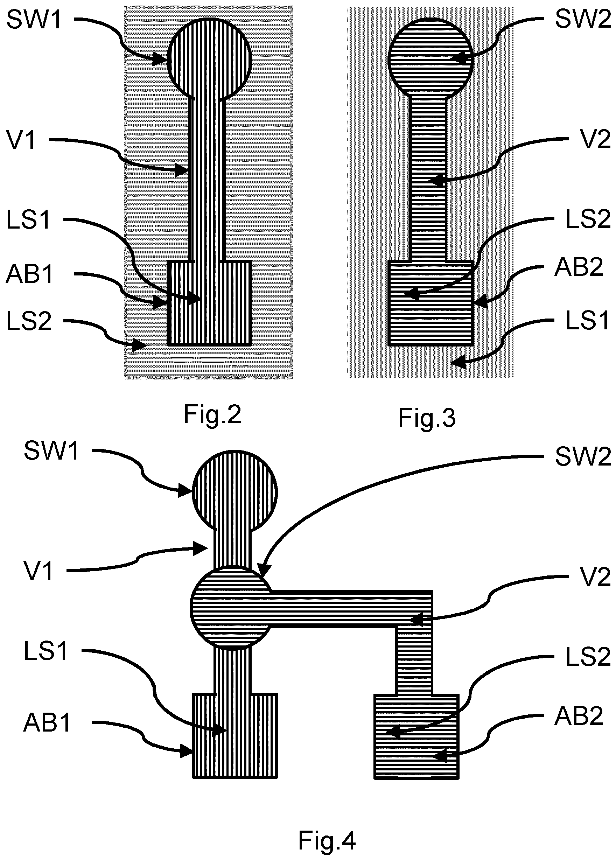

Fig. 2 zeigt eine schematische Aufsicht auf die erste elektrisch leitende Schicht LS1, unter der sich ein Teil der zweiten elektrisch leitenden Schicht LS2 befindet. Dabei kann erkannt werden, dass der unter dem ersten kapazitiv-sensitiven Elements SW1 befindliche Teil der zweiten elektrisch leitenden Schicht LS2 als Abschirmung dient. Zusätzlich kann auch vorgesehen sein, dass die (verzerrt vergrößert dargestellte) erste Zuleitungsstruktur V1 und / oder auch ein optionaler zugehöriger (verzerrt vergrößert dargestellter) Anschlussbereich AB1 ebenfalls durch einen Teil der zweiten elektrisch leitenden Schicht LS2 abgeschirmt wird.

Fig. 3 zeigt eine gleichartige schematische Aufsicht auf die zweite elektrisch leitende Schicht LS2, unter der sich ein Teil der ersten elektrisch leitenden Schicht LS1 befindet. Dabei kann erkannt werden, dass der unter dem zweiten kapazitiv-sensitiven Element SW2 befindliche Teil der ersten elektrisch leitenden Schicht LS1 als Abschirmung dient. Zusätzlich kann auch vorgesehen sein, dass die (verzerrt vergrößert dargestellte) zweite Zuleitungsstruktur V2 und / oder auch ein optionaler zugehöriger (verzerrt vergrößert dargestellter) Anschlussbereich AB2 ebenfalls durch einen Teil der ersten elektrisch leitenden Schicht LS1 abgeschirmt wird.

Dabei gilt, dass je mehr Abschirmung vorhanden ist, umso weniger Einfluss kann auf den Berührungssensor von der "ungewünschten" Seite erfolgen. Da die Zuleitungsstrukturen eher schmal gehalten werden können - in den Figuren sind die Strukturen zur Verdeutlichung übertrieben - ist eine Einflussnahme weniger gewichtig wie eine Einflussnahme auf ein kapazitiv-sensitives Element. Zudem ist in aller Regel weder am Ort der Zuleitungsstruktur noch am Ort eines optionalen Anschlussbereiches mit einer gewollten Beeinflussung zu rechnen.

D.h., durch geeignete Dimensionierung kann der Bauraum gut für eine Vielzahl von Sensoren ausgenutzt werden, wobei ein hohes Maß an (wechselseitiger) Schirmung zur Verfügung gestellt wird.

Da die elektrisch leitende Struktur der Schaltfläche nur geringe Ströme transportieren muss, kann der Flächenwiderstand der Schicht höher gewählt sein. Eine vorteilhafte erfindungsgemäße elektrisch leitfähige Schicht LS1 und LS2 weist einen Flächenwiderstand von 0,4 Ohm/Quadrat bis 200 Ohm/Quadrat auf.

Die Schaltfläche ist mit einer Sensorelektronik elektrisch, insbesondere galvanisch, kapazitiv und/oder induktiv, verbindbar. Die Sensorelektronik kann extern zur Verbundscheibe 1 oder innerhalb oder auf der Verbundscheibe 1 angeordnet sein.

Die Überdeckung von Elementen des ersten kapazitiv-sensitiven Elementes SW1 und der ersten Zuleitungsstruktur V1 ist in den Ausführungsformen der Erfindung bevorzugt kleiner oder gleich 10 % der Fläche des zweiten kapazitiv-sensitiven Elementes SW2 aus. D.h. kapazitiv beeinflussbare Bereiche des ersten kapazitiven Elementes SW1 inklusive seiner Zuleitungsstruktur V1 überdecken weniger als 1/10 der Fläche des zweiten kapazitiv-sensitiven Elementes SW2. Hierdurch wird der mögliche kapazitive Einfluss des ersten kapazitiv-sensitiven Elementes SW1 klein gehalten gegenüber dem zweiten kapazitiv-sensitiven Element SW2. D.h. trotz Überdeckung kann die Sensitivität bereitgestellt werden ohne dass es zu Fehlbedienungen kommt. Hierdurch wird eine freiere Platzierung der Berührungssensoren ermöglicht.

Gemäß einer weiteren Ausführungsform der Erfindung weist die erste strukturierte elektrisch leitende Schicht LS1 - wie in Figur 1 gezeigt - eine Höhe (auch als Dicke der Schicht bezeichnet) h_{LS1} von 10µm - 75µm auf. Ebenso kann eine zweie strukturierte elektrisch leitende Schicht LS2 vorgesehen sein. Diese zweite leitende Schicht LS2 kann ebenso eine Höhe (auch als Dicke der Schicht bezeichnet) h_{LS2} von 10µm - 75µm aufweisen. Bevorzugt weist die erste elektrisch leitende Schicht und die zweite elektrisch leitende Schicht eine Höhe von etwa 35 µm bzw. 50 µm auf. Auf der ersten elektrisch leitenden Schicht und/oder auf der zweiten elektrisch leitenden Schicht kann optional eine Haftvermittlungsschicht aufgebracht sein. Diese Haftvermittlungsschicht kann z.B. eine Höhe von jeweils etwa 15 µm aufweisen.

Dies ermöglicht eine dünne Anordnung, die auch in eine Verbundscheibe 1 integriert werden kann bzw. die auch an eine gebogene Oberfläche angepasst werden kann.

Gemäß noch einer weiteren Ausführungsform der Erfindung weisen die erste strukturierte elektrisch leitende Schicht LS1 und / oder die zweite strukturierte elektrisch leitende Schicht LS2 Kupfer, Zinn, Silber Indiumzinnoxid, Gold, Graphene und/oder Mischungen hiervon auf.

D.h. die Erfindung kann in bestehende Prozesse gut und kostengünstig eingebunden werden.

Dabei ist anzumerken, dass die Leiterschichten LS1, LS2 unterschiedliche Materialien aufweisen können. Bevorzugt weisen sie jedoch gleiche Materialien auf. D.h. die Leiterstrukturen können an elektrische und/oder thermische und/oder mechanische Randbedingungen angepasst werden.

Es sei angemerkt, dass in der ersten strukturierten elektrischen Schicht LS1 und / oder in der zweiten elektrisch strukturierten Schicht LS2 auch andere elektrische Funktionen verwirklicht sein können. Beispielsweise können Anzeigeelemente und / oder Antennen und / oder Heizelemente und / oder andere funktionale Elemente verwirklicht sein.

In einer weiteren Ausführungsform der Erfindung ist die Isolationsschicht ISO eine Folie.

D.h. die Erfindung kann in bestehende Prozesse gut und kostengünstig eingebunden werden.

Insbesondere kann z.B. für die Herstellung vorgesehen sein, dass die erste elektrisch leitende Schicht LS1 und/oder die zweite elektrisch leitende Schicht LS2 auf der Folie bereitgestellt werden.

Hierdurch kann die Folie F mit einer oder zwei strukturierten elektrisch leitenden Schichten vorkonfektioniert für die Einbringung in eine Verbundglasscheibe bereitgestellt werden.

D.h. die Strukturierung zur Bildung von Berührungssensoren kann auf einer elektrisch leitenden Schicht durch geeignete Maßnahmen bereitgestellt werden. Neben dem gezielten Aufbringen einer strukturierten elektrisch leitenden Schicht, z.B. mittels Druckverfahrens (Siebdruck, etc.) ist alternativ oder zusätzlich möglich, Strukturen durch ablative Verfahren, wie z.B. Laserstrukturierung, abschälen, abfräsen, schneiden, etc. bereitzustellen.

Die Breite der Trennlinien, welche in Figur 1 als weiße Felder dargestellt sind, beträgt bevorzugt von 30 µm bis 200 µm und besonders bevorzugt von 70 µm bis 140 µm. Derartig dünne Trennlinien erlauben eine sichere und ausreichend hohe elektrische Isolierung und stören gleichzeitig die Durchsicht durch die Verbundscheibe 1 nicht oder nur geringfügig. Die Herstellung der Trennlinien erfolgt bevorzugt durch Laserstrukturierung oder chemisches oder mechanisches Abtragen. Eine derartige Anordnung von Schaltflächen ist besonders einfach und kostengünstig herzustellen.

Die Trennlinien können frei bleiben, oder aber mit einem isolierenden Material gefüllt sein.

Ohne Beschränkung der Allgemeinheit der Erfindung kann auch die erste elektrisch leitende Schicht LS1 und/oder die zweite elektrisch leitende Schicht LS2 auf einem jeweils benachbarten Substrat GS1 / GS2 vorgesehen sein.

D.h. die Strukturierung zur Bildung von Berührungssensoren kann auf einer elektrisch leitenden Schicht durch geeignete Maßnahmen bereitgestellt werden. Neben dem gezielten Aufbringen einer strukturierten elektrisch leitenden Schicht, z.B. mittels Druckverfahrens (Siebdruck, etc.) ist alternativ oder zusätzlich möglich Strukturen durch ablative Verfahren, wie z.B. Laserstrukturierung, abschälen, abfräsen, schneiden, etc. bereitzustellen.

Die erste Substratschicht GS1 und/oder die zweite Substratschicht GS2 kann z.B. ein Glassubstrat oder ein Kunststoffsubstrat sein. Als Substrat sind im Grunde alle elektrisch isolierenden Substrate geeignet, die unter den Bedingungen der Herstellung und der Verwendung der erfindungsgemäßen Fahrzeugscheibe thermisch und chemisch stabil sind.

In Bezug auf die Figuren 2 und 3 kann in deren Zusammenschau eine Nebenordnung der Berührungssensoren in enger Nachbarschaft erkannt werden.

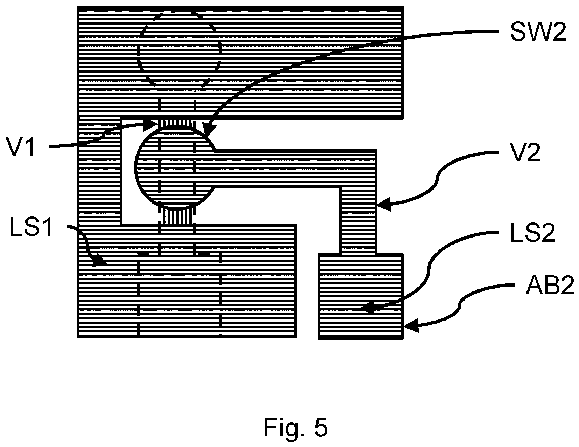

In Figur 4 ist eine Überlappung gezeigt, bei der zunächst nur die als Berührungssensoren wirkenden Teile unter Weglassung der schirmenden Teile gezeigt sind, wobei die zweite elektrisch leitende Schicht auf einer Oberseite angeordnet ist. Zum Vergleich dazu ist aus derselben Blickrichtung in Figur 5 eine schematische Ansicht der als Berührungssensoren wirkenden Teile mit schirmenden Teilen gezeigt, wobei die zweite elektrisch leitende Schicht auf einer Oberseite angeordnet ist. Wie dabei deutlich zu erkennen ist, ist hier das zweite kapazitiv-sensitive Element SW2 über der ersten Zuleitungsstruktur V1 angeordnet. Zur Vermeidung einer kapazitiven Kopplung sind die erste Zuleitungsstruktur V1 und die zweite Zuleitungsstruktur V2 ohne Überdeckung. Ist die Fläche der Zuleitungsstrukturen gering gegenüber der Fläche des kapazitiv-sensitiven Elementes SW1 / SW2 so kann auch eine teilweise oder vollständige Überlappung ermöglicht sein. Gleiches gilt für optionale Anschlussbereiche AB1, AB2.

Es ist jedoch wünschenswert, dass die äußeren Bereiche eines kapazitiv-sensitiven Elementes im Wesentlichen geschirmt sind.

Die erste Substratschicht GS1 und/oder die zweite Substratschicht GS2 enthält besonders bevorzugt Flachglas, Floatglas, Quarzglas, Borosilikatglas, Kalk-Natron-Glas oder klare Kunststoffe, vorzugsweise starre klare Kunststoffe, insbesondere Polyethylen, Polypropylen, Polycarbonat, Polymethylmethacrylat, Polystyrol, Polyamid, Polyester, Polyvinylchlorid und/oder Gemische davon.

D.h. die Erfindung kann besonders einfach auch in bestehende Materialsysteme integriert werden.

In einer weiteren Ausführungsform der Erfindung weist die Isolationsschicht ISO zumindest ein Material ausgewählt aus der Gruppe aufweisend Polyimid, Polyurethan, Polymethylenmetacrylsäure, Polykarbonat, Polyethylenterephthalat, Polyvinylbutyral, FR6, Acrylnitril-butadien-Styrol- Copolymerisat, Polyethylen, Polypropylen, Polyvinylchlorid, Polystyrol, Polybutylenterephthalat, Polyamid auf.

D.h. die Erfindung kann besonders einfach auch in bestehende Materialsysteme integriert werden.

Die erfindungsgemäße Verbundscheibe kann in Ausführungsformen der Erfindung als Fahrzeugscheibe, bzw. als Teil einer Gebäudeverglasung oder in einem Display verwendet werden

Ohne Beschränkung der Allgemeinheit kann die Verbundscheibe eine Windschutzscheibe, eine Heckscheibe, eine Seitenscheibe, oder eine Dachscheibe sein.

Gemäß einer weiteren Ausgestaltung der Erfindung wird ein Fahrzeug mit einer erfindungsgemäßen Verbundscheibe, insbesondere ein Land-, See-, Luft- oder Raumfahrzeug, bereitgestellt.

Insbesondere bei Fahrzeugen des öffentlichen Nahverkehrs, wie z.B. Bussen und Bahnen finden sich zweiseitige Schaltelemente im Glasbereich. Solche Schaltelemente dienen z.B. der Steuerung von Türen, sodass diese sowohl von Innen als auch von außen geöffnet werden können.

### Bezugszeichenliste

- 1: Verbundscheibe
- GS1: erste Substratschicht
- GS2: zweite Substratschicht
- LS1: erste strukturierte elektrisch leitende Schicht
- LS2: zweite strukturierte elektrisch leitende Schicht
- ISO: Isolationsschicht
- SW1: erstes kapazitiv-sensitives Element
- V1: erste Zuleitungsstruktur
- SW2: zweites kapazitiv-sensitives Element
- V2: zweite Zuleitungsstruktur
- AB1: Anschlussbereich
- AB2: Anschlussbereich
- h_{LS1}: Höhe der ersten strukturierte elektrisch leitende Schicht
- h_{LS2}: Höhe der zweiten strukturierte elektrisch leitende Schicht

## Patentansprüche

1. Verbundscheibe (1) mit beidseitiger Sensoranordnung, aufweisend eine erste Substratschicht (GS1) und eine zweite Substratschicht (GS2), eine erste strukturierte elektrisch leitende Schicht (LS1) und eine zweite strukturierte elektrisch leitende Schicht (LS2), sowie eine Isolationsschicht (ISO), wobei in der ersten elektrisch leitenden Schicht (LS1) ein erstes kapazitiv-sensitives Element (SW1) mit einer ersten Zuleitungsstruktur (V1) und in der zweiten elektrisch leitenden Schicht (LS2) ein zweites kapazitiv-sensitives Element (SW2) mit einer zweiten Zuleitungsstruktur (V2) gebildet ist,
• wobei die erste strukturierte elektrisch leitende Schicht (LS1) und die zweite strukturierte elektrisch leitende Schicht (LS2) zumindest durch die Isolationsschicht (ISO) voneinander getrennt sind,
• wobei die Anordnung aus erster strukturierter elektrisch leitender Schicht (LS1), zweiter strukturierter elektrisch leitender Schicht (LS2) sowie der Isolationsschicht (ISO) zwischen der ersten Substratschicht (GS1) und der zweiten Substratschicht (GS2) angeordnet ist,
• wobei das erste kapazitiv-sensitive Element (SW1) relativ zum zweiten kapazitiv-sensitiven Element (SW2) versetzt angeordnet ist, sodass zumindest Teile der ersten strukturierten elektrisch leitenden Schicht (LS1) eine Abschirmung für das zweite kapazitiv-sensitive Element (SW2) und zumindest Teile der zweiten strukturierten elektrisch leitenden Schicht (LS2) eine Abschirmung für das erste kapazitiv-sensitive Element (SW1) bilden,
**dadurch gekennzeichnet, dass** eine Überdeckung von Elementen des ersten kapazitiv-sensitiven Elementes (SW1) und der ersten Zuleitungsstruktur (V1) kleiner oder gleich 10 % der Fläche des zweiten kapazitiv-sensitiven Elementes (SW2) ausmacht.

2. Verbundglasscheibe nach Anspruch 1, **dadurch gekennzeichnet, dass** die erste strukturierte elektrisch leitende Schicht (LS1) und / oder die zweite strukturierte elektrisch leitende Schicht (LS2) eine Höhe (h_{LS1}, h_{LS2}) von 10 µm - 75 µm aufweist.

3. Verbundglasscheibe nach Anspruch 1, **dadurch gekennzeichnet, dass** die erste strukturierte elektrisch leitende Schicht (LS1) und / oder die zweite strukturierte elektrisch leitende Schicht (LS2) eine Höhe (h_{LS1}, h_{LS2}) von 50 µm aufweist.

4. Verbundglasscheibe nach einem der vorhergehenden Ansprüche, **dadurch gekennzeichnet, dass** die erste strukturierte elektrisch leitende Schicht (LS1) und / oder die zweite strukturierte elektrisch leitende Schicht (LS2) Kupfer, Zinn, Silber Indiumzinnoxid, Gold, Graphene und/oder Mischungen hiervon aufweist.

5. Verbundglasscheibe nach einem der vorhergehenden Ansprüche, **dadurch gekennzeichnet, dass** die Isolationsschicht (ISO) eine Folie ist.

6. Verbundglasscheibe nach einem der vorhergehenden Ansprüche, **dadurch gekennzeichnet, dass** die Isolationsschicht (ISO) eine Folie ist und, dass die erste strukturierte elektrisch leitende Schicht (LS1) und / oder die zweite strukturierte elektrisch leitende Schicht (LS2) auf der Folie aufgebracht sind.

7. Verbundglasscheibe nach einem der vorhergehenden Ansprüche, **dadurch gekennzeichnet, dass** die erste Substratschicht (GS1) und / oder die zweite Substratschicht (GS2) ein Glas oder Kunststoffsubstrat sind / ist.

8. Verbundglasscheibe nach einem der vorhergehenden Ansprüche 1 bis 7, **dadurch gekennzeichnet, dass** die erste Substratschicht (GS1) und / oder die zweite Substratschicht (GS2) ausgewählt sind / ist aus einer Gruppe aufweisend Flachglas, Floatglas, Quarzglas, Borosilikatglas, Kalk-Natron-Glas, Polyethylen, Polypropylen, Polycarbonat, Polymethylmethacrylat, Polystyrol, Polyamid, Polyester, Polyvinylchlorid und/oder Gemische davon.

9. Verbundglasscheibe nach einem der vorhergehenden Ansprüche, **dadurch gekennzeichnet, dass** die Isolationsschicht (ISO) zumindest ein Material ausgewählt aus der Gruppe aufweisend Polyimid, Polyurethan, Polymethylenmetacrylsäure, Polykarbonat, Polyethylenterephthalat, Polyvinylbutyral, FR6, Acrylnitril-butadien-Styrol- Copolymerisat, Polyethylen, Polypropylen, Polyvinylchlorid, Polystyrol, Polybutylenterephthalat, Polyamid aufweist.

10. Verwendung einer Verbundglasscheibe nach einem der vorhergehenden Ansprüche als Fahrzeugscheibe.

11. Verwendung einer Verbundglasscheibe nach einem der vorhergehenden Ansprüche 1 bis 9 als Teil einer Gebäudeverglasung.

## Claims

1. Composite pane (1) with a sensor assembly on both sides, comprising a first substrate layer (GS1) and a second substrate layer (GS2), a first patterned electrically conductive layer (LS1) and a second patterned electrically conductive layer (LS2), as well as an insulating layer (ISO), wherein a first capacitive sensing element (SW1) with a first supply line structure (V1) is formed in the first electrically conductive layer (LS1) and a second capacitive sensing element (SW2) with a second supply line structure (V2) is formed in the second electrically conductive layer (LS2),
- wherein the first patterned electrically conductive layer (LS1) and the second patterned electrically conductive layer (LS2) are separated from one another at least by the insulating layer (ISO),
- wherein the assembly composed of the first patterned electrically conductive layer (LS1), the second patterned electrically conductive layer (LS2), and the insulating layer (ISO) is arranged between the first substrate layer (GS1) and the second substrate layer (GS2),
- wherein the first capacitive sensing element (SW1) is arranged offset relative to the second capacitive sensing element (SW2) such that at least parts of the first patterned electrically conductive layer (LS1) form a shielding for the second capacitive sensing element (SW2) and at least parts of the second patterned electrically conductive layer (LS2) form a shielding for the first capacitive sensing element (SW1),
**characterized in that** an overlap of elements of the first capacitive sensitive element (SW1) and of the first supply line structure (V1) makes up an area less than or equal to 10% of the surface area of the second capacitive sensitive element (SW2).

2. Composite glass pane according to claim 1, **characterized in that** the first patterned electrically conductive layer (LS1) and / or the second patterned electrically conductive layer (LS2) has a height (h_{LS1}, h_{LS2}) of 10 µm - 75 µm.

3. Composite glass pane according to claim 1, **characterized in that** the first patterned electrically conductive layer (LS1) and / or the second patterned electrically conductive layer (LS2) has a height (h_{LS1}, h_{LS2}) of 50 µm.

4. Composite glass pane according to one of the preceding claims, **characterized in that** the first patterned electrically conductive layer (LS1) and / or the second patterned electrically conductive layer (LS2) comprises copper, tin, silver, indium tin oxide, gold, graphenes, and/or mixtures thereof.

5. Composite glass pane according to one of the preceding claims, **characterized in that** the insulating layer (ISO) is a film.

6. Composite glass pane according to one of the preceding claims, **characterized in that** the insulating layer (ISO) is a film and that the first patterned electrically conductive layer (LS1) and / or the second patterned electrically conductive layer (LS2) are applied on the film.

7. Composite glass pane according to one of the preceding claims, **characterized in that** the first substrate layer (GS1) and / or the second substrate layer (GS2) are / is a glass or plastic substrate.

8. Composite glass pane according to one of the preceding claims 1 through 7, **characterized in that** the first substrate layer (GS1) and / or the second substrate layer (GS2) are / is selected from a group comprising flat glass, float glass, quartz glass, borosilicate glass, soda lime glass, polyethylene, polypropylene, polycarbonate, polymethyl methacrylate, polystyrene, polyamide, polyester, polyvinyl chloride, and/or mixtures thereof.

9. Composite glass pane according to one of the preceding claims, **characterized in that** the insulating layer (ISO) comprises at least one material selected from the group comprising polyimide, polyurethane, polymethyl methacrylic acid, polycarbonate, polyethylene terephthalate, polyvinyl butyral, FR6, acrylonitrile butadiene styrene copolymer, polyethylene, polypropylene, polyvinyl chloride, polystyrene, polybutylene terephthalate, polyamide.

10. Use of a composite glass pane according to one of the preceding claims as a vehicle pane.

11. Use of a composite glass pane according to one of the preceding claims 1 through 9 as part of a building glazing.

## Revendications

1. Vitrage composite (1) avec un ensemble de capteurs sur les deux faces, comprenant une première couche de substrat (GS1) et une seconde couche de substrat (GS2), une première couche électro-conductrice structurée (LS1) et une seconde couche électro-conductrice structurée (LS2), ainsi qu'une couche isolante (ISO), dans lequel un premier élément de détection capacitif (SW1) avec une première structure de ligne d'alimentation (V1) est formé dans la première couche électro-conductrice (LS1) et un second élément de détection capacitif (SW2) avec une seconde structure de ligne d'alimentation (V2) est formé dans la seconde couche électro-conductrice (LS2),
- dans lequel la première couche électro-conductrice structurée (LS1) et la seconde couche électro-conductrice structurée (LS2) sont séparées l'une de l'autre au moins par la couche isolante (ISO),
- dans lequel l'ensemble composé de la première couche électro-conductrice (LS1), de la deuxième couche électro-conductrice (LS2) et de la couche isolante (ISO) est disposé entre la première couche de substrat (GS1) et la seconde couche de substrat (GS2),
- dans lequel le premier élément de détection capacitif (SW1) est disposé de manière décalée par rapport au second élément de détection capacitif (SW2) de sorte qu'au moins certaines parties de la première couche électro-conductrice structurée (LS1) forment un blindage pour le second élément de détection capacitif (SW2) et qu'au moins certaines parties de la seconde couche électro-conductrice structurée (LS2) forment un blindage pour le premier élément de détection capacitif (SW1),
**caractérisé par le fait qu'**un chevauchement d'éléments du premier élément de détection capacitif (SW1) et de la première structure de ligne d'alimentation (V1) représente une surface inférieure ou égale à 10 % de la surface du deuxième élément de détection capacitif (SW2).

2. Vitrage composite selon la revendication 1, **caractérisé par le fait que** la première couche électro-conductrice structurée (LS1) et/ou la deuxième couche électro-conductrice structurée (LS2) a une hauteur (hLS1, hLS2) de 10 µm - 75 µm.

3. Vitrage composite électro-conductrice conductrice (LS1) et/ou la deuxième couche électro-conductrice (LS2) a une hauteur (hLS1, hLS2) de 50 µm.

4. Vitrage composite selon l'une des revendications précédentes, **caractérisé en ce que** la première couche électro-conductrice structurée (LS1) et/ou la seconde couche électro-conductrice structurée (LS2) comprend du cuivre, de l'étain, de l'argent, de l'oxyde d'indium-étain, de l'or, des graphènes, et/ou des mélanges de ceux-ci.

5. Vitrage composite selon l'une des revendications précédentes, **caractérisé par le fait que** la couche isolante (ISO) est un film.

6. Vitrage composite selon l'une des revendications précédentes, **caractérisé par le fait que** la couche isolante (ISO) est un film et que la première couche électro-conductrice (LS1) et/ou la deuxième couche électro-conductrice (LS2) sont appliquées sur le film.

7. Vitrage composite selon l'une des revendications précédentes, **caractérisé par le fait que** la première couche de substrat (GS1) et / ou la deuxième couche de substrat (GS2) sont / est un substrat en verre ou en plastique.

8. Vitrage composite selon l'une des revendications précédentes 1 à 7, **caractérisé en ce que** la première couche de substrat (GS1) et / ou la deuxième couche de substrat (GS2) sont / est choisie dans un groupe comprenant le verre plat, le verre flotté, le verre de quartz, le verre borosilicaté, le verre sodocalcique, le polyéthylène, le polypropylène, le polycarbonate, le polyméthacrylate de méthyle, le polystyrène, le polyamide, le polyester, le chlorure de polyvinyle, et / ou leurs mélanges.

9. Vitrage composite selon l'une des revendications précédentes, **caractérisé en ce que** la couche isolante (ISO) comprend au moins un matériau choisi dans le groupe comprenant le polyimide, le polyuréthane, l'acide polyméthacrylique, le polycarbonate, le polyéthylène téréphtalate, le polybutyral de vinyle, le FR6, le copolymère acrylonitrile-butadiène-styrène, le polyéthylène, le polypropylène, le chlorure de polyvinyle, le polystyrène, le polybutylène téréphtalate, le polyamide.

10. Utilisation d'un vitrage composite selon l'une des revendications précédentes comme vitrage de véhicule.

11. Utilisation d'un vitrage composite selon l'une des revendications précédentes 1 à 9 comme élément d'un vitrage de bâtiment.
